# EUROPÄISCHE PATENTANMELDUNG

(11) **EP 3 211 114 A1**
(43) Veröffentlichungstag der Anmeldung: **30.08.2017**
(21) Anmeldenummer: 16202700.7
(22) Anmeldetag: 07.12.2016
(51) Int. Cl.: C23C 10/04, C23C 10/28, C23C 28/00

(54) **BAUTEIL AUS EINER MOLYBDÄN-LEGIERUNG UND VERFAHREN ZUR AUSBILDUNG EINER OXIDATIONSSCHUTZSCHICHT DAFÜR**

(30) Priorität: 24.02.2016 DE 102016202872
(71) Anmelder: MTU Aero Engines AG, 80995 München (DE)
(72) Erfinder: Fried, Markus, 83626 Valley (DE); Smarsly, Wilfried, 81669 München (DE); Brötzner, Andreas, 85256 Vierkirchen (DE)

(57) **Zusammenfassung**

Die vorliegende Erfindung betrifft ein Verfahren zur Verbesserung der Hochtemperaturbeständigkeit eines Bauteils, insbesondere einer Schaufel einer Strömungsmaschine, welches zumindest teilweise aus einer Molybdän - Legierung gebildet ist, die neben Molybdän, Silicium, Bor und Titan mindestens ein Element aus der Gruppe mit Eisen und Yttrium aufweist, sowie ein entsprechend hergestelltes Bauteil, wobei bei dem Verfahren zumindest an einer Außenfläche des Bauteils, die die Molybdän - Legierung aufweist, eine Diffusionssperrschicht (2) abgeschieden wird, die aus technisch reinem Molybdän oder Wolfram gebildet ist oder eine Legierung auf Basis von Molybdän und/oder Wolfram ist, die vorzugsweise mindestens eines der Elemente aus der Gruppe aufweist, die Niob und Tantal umfasst, und wobei nach dem Abscheiden der Diffusionssperrschicht (2) Silicium auf der Diffusionssperrschicht abgeschieden wird, um Molybdän - und/oder Wolframsilizide zu bilden.

## Beschreibung

### HINTERGRUND DER ERFINDUNG

### GEBIET DER ERFINDUNG

Die vorliegende Erfindung betrifft ein Bauteil aus einer Molybdän - Legierung, die Molybdän, Silicium, Bor und Titan und mindestens ein Element aus der Gruppe mit Eisen und Yttrium aufweist, insbesondere eine Schaufel einer Strömungsmaschine, wie eines Flugtriebwerks, sowie ein Verfahren zur Verbesserung der Hochtemperaturbeständigkeit eines derartigen Bauteils.

### STAND DER TECHNIK

Molybdän - Legierungen mit Anteilen von Silicium und Bor sowie weiteren Legierungselementen, die intermetallische Phasen, wie Silicide ausbilden, sind für den Einsatz in Hochtemperaturumgebungen interessant, da sie Schmelztemperaturen von über 2000°C aufweisen und auch eine ausreichende strukturelle Festigkeit aufweisen. Auf Grund der geeigneten mechanische Eigenschaften bei hohen Temperaturen sind derartige Werkstoffe auch für den Einsatz bei Strömungsmaschinen, wie stationären Gasturbinen oder Flugtriebwerken, z.B. als Schaufelwerkstoffe, interessant, da dort zumindest teilweise Werkstoffe eingesetzt werden müssen, die bei hohen Temperaturen und mechanischen Belastungen hohe Festigkeiten, wie z.B. eine hohe Kriechfestigkeit aufweisen. Allerdings ist es zudem erforderlich, dass derartige Werkstoffe auch eine gewisse Hochtemperaturbeständigkeit aufweisen, um eine ausreichende Lebensdauer der Bauteile gewährleisten zu können.

Bei den oben genannten Molybdän - Legierungen besteht jedoch noch Verbesserungsbedarf hinsichtlich der Oxidationsbeständigkeit. Zwar gibt es im Stand der Technik bereits Vorschläge zur Verbesserung der Oxidationsbeständigkeit von molybdänbasierten Legierungen, aber gerade für hochlegierte Molybdän - Legierungen mit mehreren Legierungselementen zeigen sich noch Unzulänglichkeiten.

So schlägt beispielsweise das Dokument US 7 005 191 B2 für ternäre Molybdän - Legierungen mit Molybdän, Silicium und Bor vor, auf der Oberfläche eines entsprechenden Bauteils Silicium durch chemische Dampfphasenabscheidung abzuscheiden, sodass sich eine siliziumreiche Silicidschicht mit MoSi₂ bildet. Bei Oxidation dieser siliziumreichen Silicidschicht kommt es zur Ausbildung einer langsam wachsenden Siliciumdioxidschicht, die als Oxidationsschutz fungiert, und an der Grenzfläche der Silicidschicht zum Substrat aus der Mo-Si-B - Legierung zur Ausbildung der Mo₅SiB₂ - Phase, die als Diffusionssperrschicht wirkt.

Dies ist auch im Dokument US 6 340 398 B1 für Substrate aus Molybdän - Legierungen mit zumindest 50% Molybdän beschrieben. Für Materialen, die nicht ausreichend Molybdän zur Bildung von Molybdändisilicid im Oberflächenbereich aufweisen, wie beispielsweise Metalle, wie Kupfer oder Nickel oder Legierungen davon, wird vorgeschlagen, zur Ausbildung einer entsprechenden Schutzschicht auf Basis von Siliciumdioxid zunächst eine Molybdän - Schicht aufzubringen, sodass mit der nachfolgenden Abscheidung von Silicium wieder eine Silicidschicht gebildet werden kann, die das Silicium für die Siliciumoxidschichtbildung bereitstellt.

Obwohl dieses Vorgehen, wie in der US 7 005 191 B2 für ternäre Mo-Si-B - Legierungen beschrieben, gute Ergebnisse liefert, hat sich gezeigt, dass für höher legierte Molybdän - Legierungen, also für quaternäre Molybdän - Legierungen oder Molybdän - Legierungen mit mehr als vier Legierungselementen, die hinsichtlich ihrer mechanischen Eigenschaften, Dichte und Hochtemperatureigenschaften optimiert sind, der Oxidationsschutz über eine Silicium - Anreicherung der Oberfläche und anschließende Oxidation ungenügend ist.

### OFFENBARUNG DER ERFINDUNG

### AUFGABE DER ERFINDUNG

Es ist deshalb Aufgabe der vorliegenden Erfindung ein Verfahren zur Verbesserung der Hochtemperaturbeständigkeit von hochlegierten Molybdän - Legierungen, die neben Molybdän, Silicium, Bor und Titan zumindest Eisen und/oder Yttrium enthalten, sowie entsprechend hergestellte Bauteile bereitzustellen. Gleichzeitig soll das entsprechende Verfahren zur Verbesserung der Hochtemperaturbeständigkeit einfach und zuverlässig anwendbar sein und entsprechend hergestellte Bauteile sollen sicher, zuverlässig und langlebig, insbesondere als Schaufeln in Strömungsmaschinen und insbesondere Flugtriebwerken einsetzbar sein.

### TECHNISCHE LÖSUNG

Diese Aufgabe wird gelöst durch ein Verfahren mit dem Merkmal des Anspruchs 1 sowie ein Bauteil mit dem Merkmal des Anspruchs 7. Vorteilhafte Ausgestaltungen sind Gegenstand der abhängigen Ansprüche.

Es hat sich gezeigt, dass bei hochlegierten Molybdän - Legierungen mit Silicium, Bor, Titan und mindestens Eisen oder Yttrium neben der Hauptlegierungskomponente Molybdän eine Gefügestruktur vorhanden ist, sodass bei einer Silizumanreicherung an der Oberfläche eines aus derartigen Molybdän - Legierungen hergestellten Bauteils und anschließender Oxidation Bestandteile der Molybdän - Legierung, wie beispielsweise Titan, nach außen diffundieren und dort ebenfalls Oxide bilden, die jedoch einem Oxidationsschutz durch eine langsam wachsende Siliciumdioxidschicht entgegen stehen.

Zur Abhilfe wird vorgeschlagen, auf dem Substrat aus einer Molybdän - Legierung mit Molybdän, Silicium, Bor, Titan und mindestens Eisen oder Yttrium eine Molybdän - oder Wolframschicht bzw. eine molybdänreiche bzw. wolframreiche Schicht abzuscheiden, da sich gezeigt hat, dass diese als Diffusionssperrschicht wirken kann, sodass verhindert wird, dass Bestandteile der Molybdän - Legierung nach außen diffundieren und die Ausbildung einer kompakten, langsam wachsenden Siliciumdioxidschicht beeinträchtigen. Neben reinen Molybdän - bzw. Wolframschichten können auch Mischschichten aus Molybdän und Wolfram vorgesehen werden, oder molybdänreiche bzw. wolframreiche Schichten, bei denen der weitaus überwiegende Teil, also z.B. mehr als 75 Gew.%, vorzugsweise mehr als 90 Gew.% aus Molybdän oder Wolfram gebildet sind. In der molybdänreichen bzw. wolframreichen Diffusionssperrschicht können zur Angleichung des Wärmeausdehnungskoeffizienten der Diffusionssperrschicht an den Wärmeausdehnungskoeffizienten des Substrats Niob und/oder Tantal zulegiert werden. Darüber hinaus ist es auch möglich, Molybdän durch Wolfram und umgekehrt zu substituieren, sodass auch Legierungen mit Molybdän, Wolfram, Tantal und/oder Niob für den Einsatz als Diffusionssperrschicht denkbar sind.

Die Diffusionssperrschicht kann durch physikalische Dampfphasenabscheidung und insbesondere durch Sputtern (Kathodenzerstäubung) abgeschieden werden.

Auf die Diffusionssperrschicht aus Molybdän und/oder Wolfram bzw. molybdän - und/oder wolframreichen Legierungen kann Silicium abgeschieden werden, um Molybdän - und/oder Wolframsilicide (MoSi₂, Mo₃Si, Mo₅Si₃, WSi₂, W₅Si₃) zu bilden, die für eine nachfolgende Oxidation Silicium zur Bildung einer langsam wachsenden Siliciumdioxidschicht bereitstellen. Gleichzeitig mit dem Silicium kann Bor abgeschieden werden, sodass sich in der Silicidschicht mit Molybdän - und/oder Wolframsiliciden zusätzlich Molybdän - und/oder Wolframboride (MoB, WB) und/oder Molybdän - und/oder Wolframborosilicide (Mo₅Si₃(B), W₅Si₃(B), Mo₅SiB₂, W₅SiB₂) bilden können. Durch die Zugabe von Bor in die Silicidschicht wird die Rissanfälligkeit eines entsprechenden Schichtaufbaus reduziert. Das Silicium bzw. das Silicium mit Boranteilen kann durch chemische Dampfphasenabscheidung abgeschieden werden.

Bei einer zusätzlich zu und/oder gleichzeitig mit einer Abscheidung des Siliciums und/oder Bors stattfindenden Wärmebehandlung können sich nach und/oder während des Abscheidens des Siliciums und/oder Bors die oben beschriebenen Molybdän - und/oder Wolframsilicide bilden, sodass nach diesem Verfahrensschritt eine Silicidschicht aus Molybdän - und/oder Wolframsiliciden sowie optional Molybdän - und/oder Wolframboriden sowie Molybdän - und/oder Wolframborosiliciden auf der Diffusionssperrschicht aus Molybdän und/oder Wolfram bzw. entsprechenden molybdän - und/oder wolframreichen Legierungen vorliegt. Damit weist das Bauteil bereits eine entsprechende Oxidationsschutzbeschichtung auf und kann entsprechend eingesetzt werden, da bei einem ersten Einsatz bei hohen Temperaturen bei sauerstoffhaltiger Atmosphäre automatisch durch den hohen Siliciumanteil in der Silicidschicht eine Siliciumdioxidschicht gebildet wird, die die weitere Oxidation verhindert.

Allerdings kann das Bauteil auch bereits vor dem ersten Einsatz mit einer entsprechenden Oxidschicht versehen werden, indem eine Wärmebehandlung an sauerstoffhaltiger Atmosphäre durchgeführt wird, sodass eine entsprechende Oxidschicht ausgebildet werden kann. Ist in der Silicidschicht Bor vorhanden, so kann neben Siliciumoxid auch Boroxid entstehen bzw. eine Borosilikatschicht ausgebildet werden.

Beispielhafte Legierungszusammensetzungen, die für erfindungsgemäße Bauteile verwendet werden können, sind in der nachfolgenden Tabelle angegeben (Angaben jeweils in at.%):

| Molybdän | Silicium | Bor | Titan | Eisen | Yttrium | Zirkon |
|---|---|---|---|---|---|---|
| 46,5 | 12,5 | 8,5 | 27,5 | 2,0 | 2,0 | 1,0 |
| 49,5 | 12,5 | 8,5 | 27,5 | 0 | 2,0 | 0 |
| 49,5 | 12,5 | 8,5 | 27,5 | 2,0 | 0 | 0 |
| 48,5 | 13,5 | 8,5 | 26,5 | 2,0 | 0 | 1,0 |
| 51 | 12,5 | 8,5 | 25,0 | 2,0 | 0 | 1,0 |

### KURZBESCHREIBUNG DER FIGUREN

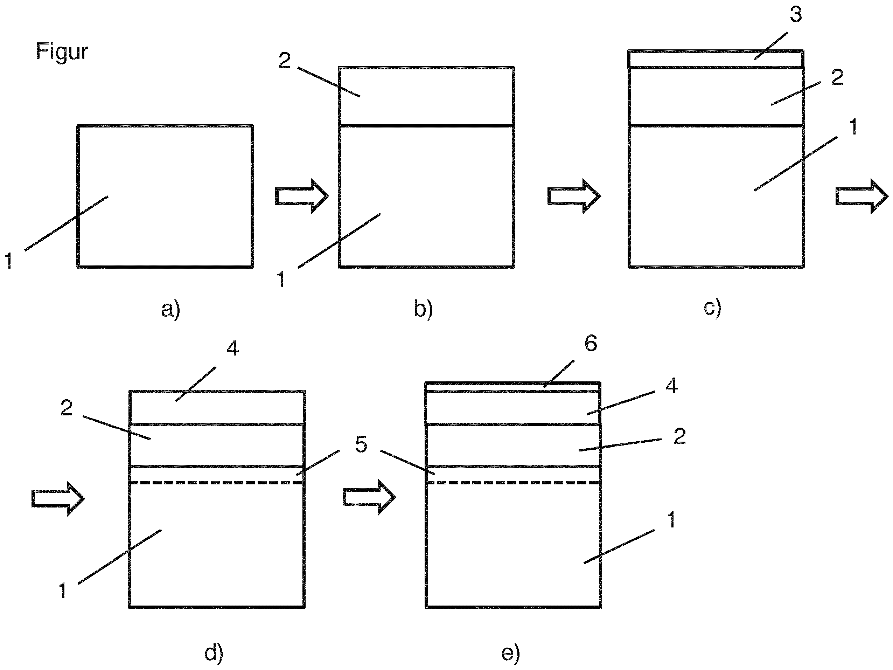

Die beigefügte Figur zeigt in rein schematischer Weise den Verfahrensablauf bei der Beschichtung eines Substrats einer Mo-Si-B-Ti-Fe-Legierung.

### AUSFÜHRUNGSBEISPIEL

Weitere Vorteile, Kennzeichen und Merkmale der vorliegenden Erfindung werden bei der nachfolgenden Beschreibung eines Ausführungsbeispiels deutlich. Allerdings ist die Erfindung nicht auf dieses Ausführungsbeispiel beschränkt.

Die beigefügte Figur zeigt in den Teilbildern a) bis e) die Verfahrensschritte bei der Aufbringung einer erfindungsgemäßen Oxidationsschutzschicht auf ein Substrat aus einer hochlegierten Mo-Si-B-Ti-Fe - Legierung mit Molybdän, Silicium, Bor, Ti und Eisen als Legierungsbestandteile, wobei der Anteil der Legierungselemente in der Reihenfolge der Aufzählung abnimmt. Als Molybdän - Legierung liegt der Hauptbestandteil Molybdän mit dem größten Anteil vor.

Im Teilschritt a) wird ein Substrat 1 bereitgestellt, welches aus einer Mo-Si-B-Ti-Fe - Legierung gebildet ist. Auf einer Oberfläche des Substrats 1 wird eine Diffusionssperrschicht 2 mittels Sputtern (Kathodenzerstäubung) abgeschieden, wobei die Diffusionssperrschicht 2 aus einer Molybdän - Legierung gebildet ist, die zur Anpassung des Wärmeausdehnungskoeffizienten an denjenigen des Substrats geringe Mengen an Tantal und/oder Niob zulegiert hat. Insbesondere kann es sich bei der Molybdän - Legierung für die Diffusionssperrschicht um eine Legierung handeln, deren Anteil an Molybdän ≥ 90 Gew.-% ist. Das Molybdän kann ganz oder teilweise auch durch Wolfram ersetzt werden.

Nach dem Abscheiden der Diffusionssperrschicht 2 in Teilschritt b) wird im Teilschritt c) Silicium mit einem geringen Anteil an Bor über eine chemische Dampfphasenabscheidung abgeschieden, sodass sich eine Siliciumschicht 3 mit einer Bordotierung auf der Diffusionssperrschicht 2 bildet. Gleichzeitig kann es durch den Temperatureinfluss bei der chemischen Dampfphasenabscheidung zu einer Eindiffusion des Siliciums in die Diffusionssperrschicht 2 bzw. Ausdiffusion von Molybdän in die aufgebrachte Siliciumschicht 3 kommen, sodass sich eine Silicidschicht 4 bildet. Dies wird im Prozessschritt d) dadurch verstärkt, dass eine Wärmebehandlung des Substrats mit den darauf abgeschiedenen Schichten 2, 3 durch geführt wird, sodass das gesamte aufgebrachte Silicium mit dem entsprechenden Boranteil in der Silicidschicht 4 enthalten ist, welche Molybdänsilicide, Molybdänboride und Molybdänborosilicide, wie beispielsweise MoSi₂, MoB, Mo₅SiB₂ aufweist. Darüber hinaus bildet sich durch den Temperatureinfluss während der Wärmebehandlung eine Diffusionszone 5 zwischen dem Substrat 1 und der Diffusionssperrschicht 2, ohne dass es jedoch zur einer Diffusion von Elementen aus dem Substrat 1 in den Außenbereich der Beschichtung kommen würde.

Nach dem Prozessschritt d) kann das entsprechend hergestellte Bauteil bereits eingesetzt werden, da bei einer Hochtemperaturanwendung an sauerstoffhaltiger Atmosphäre die Silicidschicht 4 Silicium für die Bildung von einer Siliciumoxidschicht 6 bereitstellt. Durch das Ausbilden einer Oxidschicht 6 aus langsam wachsenden Siliciumdioxid ist eine Oxidationsschutzwirkung für das entsprechend beschichtete Bauteil gegeben. Durch das in der Silicidschicht 4 enthaltene Bor in Form der Boride bzw. Borosilicide können in der Oxidschicht 6 auch Boroxide bzw. Siliciumborosilikat vorliegen.

Obwohl die Erfindung anhand des Ausführungsbeispiels deutlich beschrieben worden ist, ist für den Fachmann selbstverständlich, dass die Erfindung nicht auf dieses Ausführungsbeispiel beschränkt ist, sondern dass vielmehr Abwandlungen in der Weise möglich sind, dass einzelne Merkmale weggelassen oder andersartige Kombinationen von Merkmalen verwirklicht werden können, solange der Schutzbereich der beigefügten Ansprüche nicht verlassen wird.

### BEZUGSZEICHENLISTE

- 1: Substrat
- 2: Diffusionssperrschicht aus Mo und/oder W bzw. molybdän - und/oder wolframreichen Legierungen
- 3: Siliciumschicht
- 4: Silicidschicht
- 5: Diffusionszone
- 6: Oxidschicht

## Patentansprüche

1. Verfahren zur Verbesserung der Hochtemperaturbeständigkeit eines Bauteils, insbesondere einer Schaufel einer Strömungsmaschine, welches zumindest teilweise aus einer Molybdän - Legierung gebildet ist, die neben Molybdän, Silicium, Bor und Titan mindestens ein Element aus der Gruppe mit Eisen und Yttrium aufweist,
wobei zumindest an einer Außenfläche des Bauteils, die die Molybdän - Legierung aufweist, eine Diffusionssperrschicht (2) abgeschieden wird, die aus technisch reinem Molybdän oder Wolfram gebildet ist oder eine Legierung auf Basis von Molybdän und/oder Wolfram ist, die vorzugsweise mindestens eines der Elemente aus der Gruppe aufweist, die Niob und Tantal umfasst, und
wobei nach dem Abscheiden der Diffusionssperrschicht (2) Silicium auf der Diffusionssperrschicht abgeschieden wird, um Molybdän - und/oder Wolframsilizide zu bilden.

2. Verfahren nach Anspruch 1,
**dadurch gekennzeichnet, dass**
mit dem Silicium Bor abgeschieden wird, um Molybdän - und/oder Wolframboride und/oder Molybdän - und/oder Wolframborosilizide zu bilden.

3. Verfahren nach einem der vorhergehenden Ansprüche,
**dadurch gekennzeichnet, dass**
das Abscheiden der Diffusionssperrschicht mit Hilfe einer physikalischen Dampfphasenabscheidung, insbesondere Kathodenzerstäubung (Sputtern) erfolgt.

4. Verfahren nach einem der vorhergehenden Ansprüche,
**dadurch gekennzeichnet, dass**
das Abscheiden des Siliciums durch chemische Dampfphasenabscheidung erfolgt.

5. Verfahren nach einem der vorhergehenden Ansprüche,
**dadurch gekennzeichnet, dass**
nach dem Abscheiden des Siliciums eine Wärmebehandlung zur Ausbildung der Molybdän - und/oder Wolframsilizide erfolgt.

6. Verfahren nach einem der vorhergehenden Ansprüche,
**dadurch gekennzeichnet, dass**
nach der Ausbildung der Molybdän - und/oder Wolframsilizide eine Wärmebehandlung an sauerstoffhaltiger Atmosphäre durchgeführt wird, um eine Oxidschicht (6) zu bilden.

7. Bauteil für Hochtemperaturanwendungen, insbesondere einer Strömungsmaschine, vorzugsweise hergestellt nach einem Verfahren nach einem der vorhergehenden Ansprüche, welches zumindest teilweise aus einer Molybdän - Legierung gebildet ist, die neben Molybdän, Silicium, Bor und Titan mindestens ein Element aus der Gruppe mit Eisen und Yttrium aufweist,
wobei zumindest an einem Bereich des Bauteils, der die Molybdän - Legierung aufweist, eine Diffusionssperrschicht (2) angeordnet ist, die aus technisch reinem Molybdän oder Wolfram gebildet ist oder eine Legierung auf Basis von Molybdän und/oder Wolfram ist, die vorzugsweise mindestens eines der Elemente aus der Gruppe aufweist, die Niob und Tantal umfasst, und
wobei auf der Diffusionssperrschicht eine Schicht (4) angeordnet ist, die Molybdän - und/oder Wolframsilizide aufweist.

8. Bauteil nach Anspruch 7,
**dadurch gekennzeichnet, dass**
auf der Schicht (4) mit Molybdän - und/oder Wolframsiliziden eine Oxidschicht (6) angeordnet ist.

9. Bauteil nach Anspruch 7 oder 8,
**dadurch gekennzeichnet, dass**
das Bauteil eine Leit - oder Laufschaufel einer Strömungsmaschine ist.
